# EUROPEAN PATENT APPLICATION

(11) **EP 3 138 696 A1**
(43) Date of publication of application: **08.03.2017**
(21) Application number: 16184439.4
(22) Date of filing: 17.08.2016
(51) Int. Cl.: B44F 1/08, F25D 23/02, F25D 27/00

(54) **DOMESTIC COOLING APPLIANCE COMPRISING OPTICAL ENERGY CONSUMPTION INDICATOR**

(30) Priority: 02.09.2015 ES 201531254
(71) Applicant: BSH Hausgeräte GmbH, 81739 München (DE)
(72) Inventor: Curlewis Latorre, Tom, 31006 Pamplona (ES)

(57) **Abstract**

The invention relates to a domestic cooling appliance (1) comprising a housing (2), in which an interior (3, 4) for food is designed to be provided, and comprising a door (5, 6), which is pivotably arranged on the housing (2) for closing the interior (3, 4), wherein the domestic cooling appliance (1) has an optical operation state indicator (7), by which the operation state with regard to the energy consumption of the domestic cooling appliance (1) is indicated in color.

## Description

The invention relates to a domestic cooling appliance comprising a housing, in which an interior for food is designed to be provided. Moreover, the domestic cooling appliance has a door, which is pivotably arranged on the housing and which is designed for closing the interior.

The energy consumption of modern domestic cooling appliances is an increasingly important factor. On the one hand, the appliances are meant to consume less and less energy, on the other hand, users are growing more aware in this regard and also seek to acquire energy-saving apparatuses. In this connection it is also interesting for the user to learn what energy consumption the domestic cooling appliance has in operation.

It is therefore the task of the present invention to provide a domestic cooling appliance, in which the current energy consumption of the domestic cooling appliance can be conveyed to a user.

This task is solved by a domestic cooling appliance, which has the features according to claim 1.

A domestic cooling appliance according to the invention comprises a housing, in which an interior for food is designed to be provided. The domestic cooling appliance moreover comprises a door, which is pivotably arranged on the housing. The door is designed for closing the interior. An essential idea of the invention is to be seen in that the domestic cooling appliance has an optical operation state indicator, by which the operation state with regard to the current energy consumption of the domestic cooling appliance is indicated optically and thus only by color. Thus, a user can recognize at any time how much energy his appliance presently requires. This can be interesting for the user to the effect that he at certain times of the day and/or due to a specific filling state of the interior with specific food and/or with regard to the quantity of contained food also grows sensitive to when the energy consumption is high and when it is low. This can also contribute to the behaviour of the user with regard to the fact that the filling state of the interior with food is capable to be changed with regard to an energy-efficient operation of the domestic cooling appliance.

By an optical operation state indicator a user can also recognize at any time easily and intuitively what the current energy consumption is like.

Advantageously, it is envisaged that a first energy consumption is identified by lighting-up of the optical operation state indicator in a first color and an at least second energy consumption by lighting-up in a second color which is different from the first color. Such a design allows in a particularly simple way for recognizing the current energy consumption. The user solely from the coloring can identify the specific energy consumption. Thus, it is not required, either, to effect comprehensive indications with symbols or the like, which then may not be understood by the user or are hard to comprehend and make sense of. By such a simple coloring without any additional symbols or the like also at a larger distance from the domestic cooling appliance the current energy consumption can immediately be recognized.

Preferably it is envisaged that the energy consumption is subdivided into at least three, in particular four categories and that each category is assigned a color of its own for optical indication. By such a specific number of categories, on the one hand, an energy consumption information, which is not too delicate and then no longer understandable by the user for being overladen, is conveyed. On the other hand, at least in such a rough classification differentiating between a very energy-efficient operation and an operation, which in this regard is inefficient, with then two further categorization steps provided in between an information is conveyed.

Since particularly in connection with such a categorization of at least three, in particular only four categories also a then very signalizing color assignment is facilitated, a user can clearly distinguish these then different energy consumption states also on the basis of color.

Preferably it is envisaged that the best and thus the most energy-efficient operation is identified by a green color, which is emitted by the optical operation state indicator. An energy consumption of the domestic cooling appliance, which in comparison is somewhat worse, but still good, by contrast can be characterized by a blue colour. An energy consumption state, which in comparison is slightly worse, can then be characterized by a yellow color. An energy consumption state, which is the worst one within the categorization, in this connection can be characterized by a red color.

Preferably it is envisaged that the optical operation state indicator has a strip-type or a linear light-emitting element. Thereby a very uniform and longitudinal, but thin light information is emitted, which can easily be recognized, but does not glare and is not dominant in an undesired way and also does not excessively illuminate a user. By such a design a light information which is very unobtrusive but can be recognized at any time can be presented. Moreover, owing to such a design the light-emitting element per se is also of a very space-saving and delicate design so that it also in the context of the overall design of the domestic cooling application with regard to geometry and position is not primarily perceived, but merely the resulting light emission and the corresponding color are unambiguously perceived.

Preferably it is envisaged that the light emission for optical indication of the energy consumption is designed to be provided at a bottom edge of the door. This is a particularly advantageous design as thus the light-emitting element viewed per se is also arranged in a protected manner and by the door at least from the top and in particular also by the forwardly projecting design of the door relative to the light emission element the protection is formed. Moreover, this design is particularly advantageous also for the emission and thus for the optical effect. This is because the bottom edge of the door and thus the narrow edge side of the door forms also a certain shield towards the top so that no undesired emission towards the top is effected. By this bottom edge of the door thus also a kind of shadow gap is generated, from which then the light emission is effected.

If this bottom edge of the door is made of a metal or a reflecting material, the light emission is also individually guided and intensified or reflected so that the defined light emission also guided towards the front or at an angle downwards is promoted. The above-named advantages are thereby even improved.

Preferably it is envisaged that the light emission is designed to be provided across the entire width of the bottom edge of the door. Thereby a very uniform optical effect with regard to the perception of the optically indicated energy consumption state of the domestic cooling appliance is generated. It is not the case that then any random kind of light emission is formed locally in one spot or an individually asymmetrical position, which possibly may also be misinterpreted by a user, but by this then in particular horizontal line across the entire width also an easily understandable optical information effect is generated.

Preferably the optical operation state indicator has a light-emitting diode as light source. A light-emitting diode as such is very compact and thus is capable of being attached in a space-saving manner. Moreover, it is very energy-saving itself, however, can provide high light yield over an extended operational life span. Moreover, it is possible that here only a light-emitting diode is employed, which however for emission is subdivided into different light colors. Thus, also the number of light sources may be reduced, which again is advantageous for the energy consumption of the domestic cooling appliance.

Preferably, it is envisaged that the domestic cooling appliance has a thermostat and the information of the thermostat when determining the current energy consumption of the domestic cooling appliance is considered. In particular with the thermostat a temperature in the interior of the domestic cooling appliance is captured.

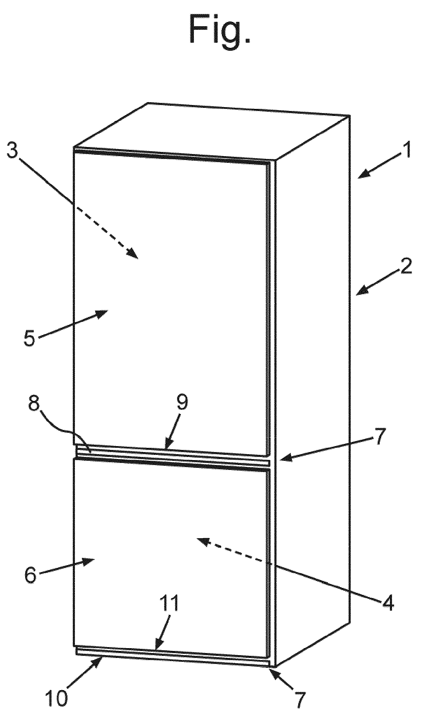

An embodiment of the invention is explained in the following in more detail by referring to a schematic drawing. The only figure in this connection shows a simplified perspective view of an embodiment of a domestic cooling appliance according to the invention. The domestic cooling appliance 1 according to the invention can be designed to be provided as a cooling appliance or as freezer or as fridge-freezer. In the shown embodiment it is a fridge-freezer combination device. The domestic cooling appliance 1 comprises a housing 2, in which a first interior 3 and a second interior 4, which is separate therefrom, are designed to be provided. For instance the interior 3 can be a cooling space and the interior 4 can be a freezer space.

At the front face the interior 3 is capable of being closed by a door 5, which is pivotably arranged on the housing 2.

The domestic cooling appliance 1 moreover comprises a further door 6, which is separate from the door 5 and which is equally pivotably arranged on the housing 2 and is designed for closing the further interior 4.

The domestic cooling appliance 1 moreover comprises an optical operation state indicator 7, by which the operation state of the domestic cooling appliance 1 with regard to its energy consumption is capable of being optically indicated by simple color emission or only by the color emission as such. The optical indication in this connection is merely effected by an individual color emission and no symbols are shown or backlit. The optical operation state indicator 7 for this purpose comprises a first light emission element 8, which extends essentially across the entire width of the door 5. The light-emitting element 8 is arranged directly adjacent and viewed in the vertical direction below a bottom edge 9 of the door 5. Preferably it may be envisaged that this light-emitting element 8 is arranged on a front face flange of the housing 2.

Moreover, it is envisaged in the embodiment that the optical operation state indicator 7 has a further light-emitting element 10, which preferably is equally arranged on the housing 2, and there on a front flange. This further light-emitting element 10 is arranged in the vertical direction directly adjacent below a bottom edge 11 of the door 6. The bottom edge 9 as well as the bottom edge 11 are in particular arranged in such a way that viewed in the depth direction they project towards the front relative to the light-emitting element 8 or 10 so that by the bottom edges 9 and 11a kind of cover or shield from above is effected.

The optical operation state indicator 7 is designed in such a way that a first energy consumption is identified by lighting-up of the optical operation state indicator 7 in a first color and a second energy consumption is identified by lighting-up in a second color that is different from the first color.

In the embodiment it is preferably envisaged that the energy consumption of the domestic cooling appliance 1 is subdivided into four categories and that in each category a color of its own can be indicated for optical indication via this optical operation state indicator 7.

For this purpose it is in particular envisaged that the most energy-efficient operation state is characterized by a green color, which then is capable of being emitted via the light-emitting element 8 and/or 10. In this connection in particular the light-emitting element 8 with regard to the energy-efficient operation is assigned to the interior 3 and the light-emitting element 10 with regard to the energy consumption is assigned to the interior 4.

An, in comparison thereto, less efficient energy consumption is then characterized by a blue color. The third category, which then, in turn, characterizes an even less energy-efficient operation, is characterized by a yellow light color. The least energy-efficient operation with regard to the four categories and thus the operation with the highest energy consumption is characterized by a red color in the embodiment. The light-emitting elements 8 and 10 are designed to be provided as strip-type or linear elements so that the emitted light color appears as horizontal light band or as horizontal light strip.

The domestic cooling appliance 1 can preferably have at least one thermostat, by means of which the temperature can be captured in the interior 3 and/or 4. It may be envisaged that the information of the thermostat is considered when determining the current energy consumption of the domestic cooling appliance 1.

### REFERENCES

- 1: domestic cooling appliance
- 2: housing
- 3: interior
- 4: interior
- 5: door
- 6: door
- 7: operation state indicator
- 8: light-emitting element
- 9: bottom edge
- 10: light-emitting element
- 11: bottom edge

## Claims

1. A domestic cooling appliance (1) comprising a housing (2), in which an interior (3, 4) for food is designed to be provided, and comprising a door (5, 6), which is pivotably arranged on the housing (2) for closing the interior (3, 4), **characterized in that** the domestic cooling appliance (1) has an optical operation state indicator (7), by which the operation state with regard to the energy consumption of the domestic cooling appliance (1) is indicated in color.

2. The domestic cooling appliance (1) according to claim 1, **characterized in that** a first energy consumption is identified by lighting-up of the optical operation state indicator (7) in a first color and a second energy consumption by lighting-up of the optical operation state indicator (7) in a second color which is different from the first color.

3. The domestic cooling appliance (1) according to claim 1 or 2, **characterized in that** the energy consumption is subdivided into at least three, in particular four, categories and each category is assigned a color of its own for optical indication.

4. The domestic cooling appliance (1) according to any one of the preceding claims, **characterized in that** the optical operation state indicator (7) has a strip-type or linear light-emitting element (8, 10).

5. The domestic cooling appliance (1) according to any one of the preceding claims, **characterized in that** the light emission for optical indication of the energy consumption is designed to be provided adjacent to a bottom edge (9, 11) of the door (5, 6).

6. The domestic cooling appliance (1) according to claim 5, **characterized in that** the light emission is designed to be provided over the complete width of the bottom edge (9, 11) of the door (5, 6).

7. The domestic cooling appliance (1) according to any one of the preceding claims, **characterized in that** the optical operation state indicator (7) has a light-emitting diode as light source.

8. The domestic cooling appliance (1)) according to any one of the preceding claims, **characterized in that** it has a thermostat and the information of the thermostat is considered when determining the current energy consumption of the domestic cooling appliance (1).
